# EUROPÄISCHE PATENTSCHRIFT

(11) **EP 0 775 030 B1**
(45) Veröffentlichungstag und Bekanntmachung des Hinweises auf die Patenterteilung: **02.05.2001**
(21) Anmeldenummer: 95927640.3
(22) Anmeldetag: 07.08.1995
(51) Int. Cl.: B22D 27/04, C30B 11/00

(54) **VERFAHREN UND VORRICHTUNG ZUM GERICHTETEN ERSTARREN EINER SCHMELZE**
METHOD AND DEVICE FOR DIRECTIONALLY SOLIDIFIYING A MELT
PROCEDE ET DISPOSITIF PERMETTANT UNE SOLIDIFICATION DIRIGEE D'UNE MATIERE FONDUE

(30) Priorität: 08.08.1994 WO PCT/DE94/00914
(43) Veröffentlichungstag der Anmeldung: 28.05.1997
(60) Teilanmeldung: 00104497.3
(73) Patentinhaber: SIEMENS AKTIENGESELLSCHAFT, 80333 München (DE)
(72) Erfinder: SINGER, Robert, D-91054 Erlangen (DE); FITZGERALD, Thomas, D-91054 Erlangen (DE); KRUG, Peter, D-90427 Nürnberg (DE)
(86) Internationale Anmeldenummer: DE9501034
(87) Internationale Veröffentlichungsnummer: WO9605006

(56) Entgegenhaltungen:
- EP-A- 0 010 538
- EP-A- 0 631 832
- DE-A- 1 953 716
- DE-A- 2 242 111
- DE-A- 2 815 818

## Beschreibung

Die Erfindung betrifft ein Verfahren und eine Vorrichtung zum gerichteten Erstarren einer Schmelze eines ersten Metalls in einer Gießform, wobei das Verfahren das Bereitstellen der Schmelze in der Gießform auf einer ersten Temperatur oberhalb des Schmelzpunktes des ersten Metalls und anschließendes Abkühlen der Schmelze in der Gießform durch Eintauchen der Gießform in ein Bad aus einem flüssigen zweiten Metall, welches sich auf einer zweiten Temperatur befindet, welche unterhalb des Schmelzpunktes des ersten Metalls liegt, umfaßt und wobei die Vorrichtung eine Heizkammer, welche eine Heizzone zur Warmhaltung der Schmelze und der Gießform auf einer ersten Temperatur oberhalb des Schmelzpunktes des ersten Metalls, einen unterhalb der Heizkammer angeordneten Tiegel mit einem Bad aus einem flüssigen zweiten Metall, welches sich auf einer zweiten Temperatur befindet, die unterhalb des Schmelzpunktes des ersten Metalls liegt, sowie eine Fahreinrichtung zur Bewegung der Gießform aus der Heizzone in das Bad umfaßt.

Ein Verfahren bzw. eine Vorrichtung zum gerichteten Erstarren einer Schmelze wird angewendet, wenn aus einer Schmelze ein Gußstück mit stengelkristallinem oder einkristallinem Gefüge gebildet werden soll. Dies kommt insbesondere in Frage bei der Herstellung einer Turbinenschaufel für eine Gasturbine aus einer Schmelze einer Nickelbasis- oder Kobaltbasis-Legierung, insbesondere einer Superlegierung.

Unter einem stengelkristallinen Gefüge wird in jedem Fall ein vielkristallines Gefüge verstanden, welches aus langgestreckten, stengelförmigen Kristalliten besteht, die alle entlang einer bestimmten Achse ausgerichtet sind. Dieses Gefüge ist besonders widerstandsfähig gegen Belastungen, die entlang der Achse gerichtet sind. Unter einem einkristallinen Gefüge wird in der Tat das Gefüge eines Einkristalls verstanden, letztlich also ein Werkstück, welches im wesentlichen ein einziger Kristall ist. Hinweise dazu sind der EP 0 092 496 B1 entnehmbar.

Die Bildung von Einkristallen aus Schmelzen ist auch auf dem Gebiet der Halbleitertechnik bekannt, wobei hier bislang andere als die bisher beschriebenen Verfahren und Vorrichtungen eingesetzt werden. In letzter Zeit gibt es aber Forschungsanstrengungen, bei denen Verfahren und Vorrichtungen ähnlich den für metallische Werkstoffe bekannten eingesetzt werden. Im Zusammenhang mit der gerichteten Erstarrung metallischer Schmelzen sind mehrere Möglichkeiten zur Erzielung eines einkristallinen Gefüges bekannt. Die bevorzugte Möglichkeit liegt nach der EP 0 092 496 B1 darin, die Schmelze in einer Gießform erstarren zu lassen, die an ihrem unteren Ende eine spiralförmig gekrümmte Einschnürung aufweist, wobei unterhalb der Einschnürung zunächst ein stengelkristallines Gefüge entsteht, von dem aus nur ein einziger Stengelkristall die Einschnürung durchwachsen und somit zum Ausgangspunkt der Kristallisation der Schmelze oberhalb der Einschnürung werden kann. Alternativ dazu ist es möglich, in die Gießform einen sogenannten Impfkristall, d.h. einen kleinen Einkristall, einzulegen, von dem aus die Schmelze unter Beibehaltung der Orientierung des Impfkristalls kristallisieren kann. Hierbei sind selbstverständlich Vorkehrungen erforderlich, um ein vollständiges Aufschmelzen des mit der zu erstarrenden Schmelze zu bedeckenden Impfkristalls zu vermeiden.

Ein Verfahren und eine Vorrichtung der eingangs genannten Art gehen hervor aus der DE 28 15 818 A1. Das in jedem Fall vorgesehene Eintauchen der Gießform in das kühlende Bad, welches insbesondere aus flüssigem Zinn besteht, dient dazu, in der Gießform und der Schmelze eine Zone mit einem steilen vertikalen Temperaturgradienten zu erzeugen, die mit zunehmendem Eintauchen der Gießform in das Bad entgegen der Richtung, in der die Gießform eingetaucht wird, durch die Schmelze wandert. Ein möglichst steiler Temperaturgradient ist erwünscht, weil er die Bildung eines günstigen Gefüges bewirkt. Er geht einher mit einer hohen Abkühlungsrate beim Eintauchen der Gießform mit der Schmelze in das Bad. Unter einem günstigen Gefüge versteht man in diesem Fall ein Gefüge, das weitgehend frei ist von Inhomogenitäten, Segregationen, niedrig schmelzenden Nichtgleichgewichtsphasen und Poren und somit gute mechanische Eigenschaften aufweist. Ein weiterer Vorteil des steilen Temperaturgradienten ist, daß er einen schnellen und kostengünstigen Fertigungsprozeß ermöglicht. Die Ausbildung eines hohen Temperaturgradienten wird allerdings konterkariert durch eine von der Heizzone ausgehende intensive Wärmestrahlung, die bedingt ist durch die in der Heizzone herrschende hohe Temperatur von üblicherweise um 1600 °C. Diese Wärmestrahlung kann das Bad stark aufheizen, was zu einer beträchtlichen Verringerung des erzielbaren Temperaturgradienten und zu einem Verdampfen des Bades führen kann, insbesondere dann, wenn gemäß üblicher Praxis das gerichtete Erstarren der Schmelze unter Vakuum erfolgen soll. Um diese nachteiligen Effekte auszuschließen und zu verhindern, daß Strahlung aus der Heizkammer das Bad erwärmt, ist an der Unterseite der Heizkammer ein zur Gießform hin gerichteter, allgemein als "Baffle" bezeichneter Strahlungsschirm vorgesehen, der das Bad gegen die Heizzone abschirmen soll. Zusätzlich schwimmt auf der Kühlschmelze eine Trennplatte aus einem wärmeisolierenden Material, welche zum Eintauchen der Gießform in 'die Kühlschmelze eine Öffnung hat. Die mit dieser Anordnung erzielbare Wärmedämmung ist allerdings unvollkommen, insbesondere dann, wenn ein Gußstück mit variablem Querschnitt hergestellt werden soll und demgemäß eine Gießform mit ebenfalls stark veränderlichem Querschnitt verwendet werden muß. In diesem Fall müssen Strahlungsschirm und Trennplatte auf den größten Querschnitt der Gießform abgestimmt sein. Dies führt allerdings dann, wenn ein Bereich der Gießform mit deutlich verringertem Querschnitt durch das Baffle und die Trennplatte in das Bad eintreten soll, zur Entstehung eines Spaltes, der das Durchtreten von Wärmestrahlung zu dem Kühlbad erlaubt und sich demgemäß nachteilig auf den erzielbaren Temperaturgradienten auswirkt.

Die DE-AS 19 53 716 zeigt bereits einen Behälter mit einem Bad zur Abkühlung einer Schmelze in einer Gießform, wobei die Oberfläche des Bades mit einer wärmeisolierenden Deckschicht bedeckt ist. Das Bad besteht aus flüssigem Blei. Die wärmeisolierende Schicht hat den Sinn, ein Oxidieren und ein übermäßig starkes Abkühlen des Bades zu verhindern. Die Kühlschmelze steht in keinerlei unmittelbarer Beziehung zu einer Heizvorrichtung; das Bad wird benutzt, indem zunächst die leere Gießform hineingegeben und anschließend mit der zu erstarrenden Schmelze befüllt wird. Ein gerichtetes Erstarren der Schmelze ist nicht vorgesehen. Ebensowenig ist die Erzielung einer besonderen Verteilung der Temperatur im Inneren der Schmelze oder des daraus gebildeten Gußstücks ein Thema.

Aus der DE 22 42 111 B2 ist es bei einem Verfahren und bei einer Vorrichtung der eingangs genannten Art bekannt, die Oberfläche des Bades so dicht unterhalb der Heizkammer vorzusehen, daß eine am unteren Ende der Gießform vorgesehene Kühlplatte schon vor dem Eintauchen der eigentlichen Gießform zumindest teilweise in das Bad eintaucht. Hierdurch wird die Kühlplatte auch dann auf einer der Temperatur des Bades entsprechenden Temperatur gehalten, wenn die Gießform sich noch in der Heizzone befindet und womöglich noch nicht gefüllt ist'. Hierdurch wird die Kühlung der Schmelze am unteren Ende der Gießform intensiviert und darüber hinaus eine gewisse zusätzliche Abschirmung des Bades vor der von der Heizzone ausgehenden Hitzestrahlung erreicht. Ergänzend ist an einem unteren Ende der Heizkammer ein besonderer Hitzeschild vorgesehen. Zur Vergleichmäßigung der Temperatur in dem Bad ist eine Rührvorrichtung vorgesehen, mit der das Bad umgewälzt werden kann.

Zu allen bekannten Verfahren und Vorrichtungen zum gerichteten Erstarren einer Schmelze sei festgestellt, daß sie zur Herstellung von Gußstücken mit Abmessungen, die einen Wert von 10 cm deutlich überschreiten, nur bedingt geeignet sind. Der Grund liegt im wesentlichen darin, daß die bisher erzielbaren Temperaturgradienten für ein zuverlässiges gerichtetes Erstarren größerer Schmelzen nicht ausreichen, wobei sich die geschilderte Problematik aufgrund der Einstrahlung, von Wärme aus der Heizzone in das Bad bei größeren Gußstücken mit variierenden Querschnitten zusätzlich störend auswirkt. Probleme stellen sich bei den bekannten Verfahren und Vorrichtungen auch ein, wenn vielzählige, nach Art einer Traube untereinander und mit einem gemeinsamen Eingußkanal verbundene Gußstücke gleichzeitig hergestellt werden sollen, da in einem solchen Fall die in den Gußstücken erzielbaren Temperaturgradienten wegen weiter verringerter Abschirmmöglichkeit nochmals verringert sind.

Die Aufgabe, von der die Erfindung ausgeht, liegt daher darin, das Verfahren und die Vorrichtung der eingangs genannten Art derart weiterzuentwickeln, daß eine gegenüber dem Stand der Technik wesentlich verbesserte Abschirmung des Bades und ein gegenüber den Möglichkeiten des Standes der Technik wesentlich höherer Temperaturgradient beim Einführen der Gießform mit der Schmelze in das Bad erzielt wird. Vorzugsweise sollen ein günstigeres Gefüge für die erstarrte Schmelze und eine kürzere Herstellungszeit erreicht werden. Es sollen auch größere Gußstücke unter Gewährleistung des gerichteten Erstarrens und unter Vermeidung einer Überhitzung und/oder Verdampfung des Bades hergestellt werden können.

Zur Lösung der Aufgabe, soweit sie sich auf ein Verfahren bezieht, wird ein Verfahren zum gerichteten Erstarren einer Schmelze eines ersten Metalls in einer Gießform angegeben, umfassend Bereitstellung der Schmelze in der Gießform auf einer ersten Temperatur oberhalb des Schmelzpunktes des ersten Metalls und anschließendes Abkühlen der Schmelze in der Gießform durch Eintauchen der Gießform in ein Bad aus einem flüssigen zweiten Metall, welches sich auf einer zweiten Temperatur befindet, die unterhalb des Schmelzpunktes des ersten Metalls liegt, wobei das Bad bedeckt ist von einer schwimmenden, fließfähigen Deckschicht aus wärmeisolierenden Hohlkörpern und die Gießform mit der Schmelze durch die Deckschicht hindurch in das Bad eingetaucht wird.

EP-A-631 832, ein älteres, jedoch nach dem Prioritätstag der Erfindung veröffentlichtes Dokument nach Art. 54 (3) EPÜ, beschreibt alle Merkmale der Erfindung mit Ausnahme der Ausbildung des als fließfähige Deckschicht dienenden Keramikmaterials als Hohlkörper.

Die erfindungsgemäß eingesetzte Deckschicht aus fließfähigen Hohlkörpern schirmt das Bad vollständig ab, auch während die Gießform in das Bad eintritt, da die fließfähigen Hohlkörper die Gießform stets eng umschließen selbst dann, wenn sich ihr Querschnitt während des Durchdringens der Deckschicht verändert und auch dann, wenn die Gießform eingerichtet ist zur Aufnahme mehrerer voneinander beabstandeter Schmelzen, wie dies im Stand der Technik gelegentlich beschrieben und oben bereits erläutert ist.

Mit der Erfindung ist erstmalig eine weitgehend vollständige Verhinderung eines wesentlichen Wärmeeintrags in das Bad möglich, während eine Schmelze in gerichteter Weise erstarrt wird. Dabei ermöglicht die Erfindung eine wesentliche Vergrößerung des beim Erstarren einer Schmelze wirksamen Temperaturgradienten und erlaubt aufgrund der erreichbaren schnellen Abkühlung die Erzielung besserer Eigenschaften sowie eine hohe Produktivität bei der Serienfertigung von Gußstücken. Auf dieser Grundlage ermöglicht die Erfindung auch die rationelle und serienweise Fertigung von Gußstücken mit deutlich größeren Abmessungen und/oder größeren Trauben von Gußstücken als bisher und erschließt die Anwendung der gerichteten Erstarrung für Komponenten von stationären Gasturbinen mit Nennleistungen bis 200 MW und darüber hinaus, insbesondere für Turbinenschaufeln.

Die Deckschicht kann mit relativ geringem Aufwand und kostengünstig erzeugt werden, indem zu ihrer Bildung fließfähige und isolierfähige Hohlkörper verwendet werden. Als solche Hohlkörper kommen insbesondere keramische Hohlkugeln, zum Einsatz. Diese Hohlkörper bestehen vorzugsweise aus Aluminiumoxid-Siliziumdioxid-Keramik, insbesondere Mullit, und haben Außendurchmesser zwischen 0,5 mm und 3 mm, vorzugsweise von etwa 1 mm.

Anforderungen an die Materialien, die zur Bildung der Deckschicht in Frage kommen, sind eine geringe Wärmeleitfähigkeit und gute Schwimmfähigkeit auf dem Bad, sowie, zur Gewährleistung der Fließfähigkeit der Deckschicht, eine möglichst geringe Neigung, bei den an der Deckschicht, anliegenden Temperaturen untereinander zu verkleben oder zu versintern. Auch ist bedeutsam, daß die Bestandteile der Deckschicht nicht wesentlich von dem zweiten Metall benetzbar sind, da derart sichergestellt ist, daß das zweite Metall sich nicht in die Deckschicht eingelagert und bis zu der der Heizzone ausgesetzten Oberfläche transportiert wird, wobei mit einer Verdampfung sowie mit Beeinträchtigungen der Isolierfähigkeit und Fließfähigkeit der Deckschicht zu rechnen wäre.

Ein Werkstoff, der den vorgenannten Anforderungen gerecht wird, ist das erwähnte Mullit, zu verwenden vorzugsweise in Form von Hohlkugeln. Die Deckschicht sollte dabei vorzugsweise eine Schüttung von Hohlkugeln mit übereinstimmenden Außendurchmessern sein, wobei für Außendurchmesser von etwa 1 mm besonders gute Ergebnisse erwartet werden. Die Verwendung von Hohlkugeln mit deutlich größeren Außendurchmessern sowie die Verwendung von Hohlkugeln mit unterschiedlichen Durchmessern werden als weniger günstig betrachtet. Als Material für die Hohlkörper, welche bevorzugterweise als Hohlkugeln ausgebildet sind, kommen keramische Oxide, wie das erwähnte Mullit, sowie Aluminium-, Magnesium- oder Zirkonoxid in Frage. Bevorzugtermaßen haben die Hohlkörper einen Durchmesser zwischen 0,5 mm und 3 mm, vorzugsweise etwa 1 mm. Die Verwendung von Hohlkugeln zeichnet sich durch eine besonders gute Raumausnutzung ohne wesentliche Hohlräume zwischen den Hohlkugeln aus, wodurch eine gute Wärmeisolierung gegeben ist.

Als Alternative zu den Hohlkugeln aus Mullit ist eine Deckschicht in Form einer Schüttung von Hohlkörpern aus Aluminium-, Magnesium- oder Zirkonoxid denkbar, wobei die Hohlkörper aus Pulverteilchen bestehen sollten, deren Außendurchmesser zwischen einer unteren Grenze von 0,06 mm und einer oberen Grenze von 0,4 mm liegen.

Eine bevorzugte Weiterbildung des Verfahrens besteht darin, die Gießform mit der Schmelze zunächst in einer Heizzone auf der ersten Temperatur zu halten und anschließend aus der Heizzone in das Bad einzutauchen, wobei zumindest dann, wenn die Gießform in die Deckschicht eintaucht, die Deckschicht unmittelbar an die Heizzone heranreicht. Der Abstand zwischen der Heizzone und dem Bad muß möglichst klein sein, um einen möglichst großen Temperaturgradienten in der zu erstarrenden Schmelze zu erhalten. Bei einer entsprechenden Anordnung ist außerdem gewährleistet, daß eine besonders günstige Anfangsposition für die Gießform möglich ist. In dieser Anfangsposition taucht eine unter der Gießform befindliche Kühlplatte bereits in das Bad ein, während die noch zu befüllende Gießform etwa mit dem unteren Ende der Heizzone abschließt. So ist beim Eintauchen der Gießform eine besonders hohe anfängliche Erstarrungsgeschwindigkeit erreichbar. Für diese Maßnahme sind mehrere Realisierungsmöglichkeiten denkbar. So kann z. B. ein Tiegel, der das Bad enthält, so groß gemacht werden, daß er bis an die Heizzone heranreicht und über dem Bad bis an die Heizzone mit dem die Deckschicht bildenden Schüttgut gefüllt wird; eine Alternative liegt darin, den Tiegel und eine Heizkammer, in der die Heizzone vorgesehen ist, gegeneinander beweglich auszuführen und vor dem Eintauchen der Gießform in das Bad einander entsprechend anzunähern.

Generell wird für die Deckschicht eine Dicke zwischen 30 mm und 50 mm bevorzugt, wobei diese Dicke zumindest während des Eintauchens der Gießform in das Bad gewährleistet sein sollte. Eine solche Dicke wird den Isolierungsanforderungen aufgrund der intensiven Wärmestrahlung, mit der die Deckschicht im Regelfall beaufschlagt wird, in besonderer Weise gerecht.

Mit weiterem Vorzug erfolgt die Durchführung des Verfahrens unter Ausschluß von Sauerstoff, vorzugsweise unter Vakuum, zum Zwecke der Vermeidung oxidischer Schlacken auf dem Bad. Dies ist wichtig, um ein durch Schlacken u. U. begünstigtes Verkleben des Schüttgutes in der Deckschicht zu vermeiden. Vor allem dann, wenn als zweites Metall Zinn verwendet wird, wird bevorzugtermaßen die Deckschicht unter einem Vakuum mit einem Restdruck von höchstens 10⁻³ mbar, weiter bevorzugt von höchstens 10⁻⁴ mbar, gehalten. Neben der Vermeidung der Neuentstehung von Oxid aus dem zweiten Metall wird, wenn das zweite Metall Zinn ist oder Zinn enthält, bei einem solchen Vakuum auch die Zersetzung eventuell bereits vorliegenden Zinnoxids und damit eine Reinigung des Bades und der Deckschicht erreicht. Dieser Effekt beruht auf der chemischen Instabilität und entsprechender Neigung zur Zersetzung des Zinnoxids bei den für das Bad üblicherweise in Frage kommenden Temperaturen; wird durch Bereitstellung eines hinreichend guten Vakuums die Abfuhr des bei der Zersetzung anfallenden Sauerstoffs gesichert, so kann eventuell vorliegendes Zinnoxid vollständig beseitigt werden.

Das Verfahren jedweder Ausgestaltung findet vorzugsweise Verwendung zum gerichteten Erstarren eines ersten Metalls in Form einer Nickelbasis- oder Kobaltbasis-Legierung, insbesondere einer Superlegierung, wie sie im Zusammenhang mit Turbinenschaufeln für Gasturbinen üblicherweise in Betracht gezogen wird.

Das zweite Metall, welches das Bad bildet, ist vorzugsweise Aluminium oder Zinn, wobei dem Zinn ein besonderer Vorzug gebührt. Unter Verwendung von Zinn kann das Bad auf einer zweiten Temperatur unterhalb von 500 °C, vorzugsweise bei etwa 300 °C, gehalten werden, und somit ist eine besonders hohe Temperaturdifferenz zwischen dem Schmelzpunkt des ersten Metalls und der Temperatur des Bades möglich. Eine möglichst niedrige zweite Temperatur bewirkt außerdem eine Verringerung der Gefahr, daß das zweite Metall in nennenswertem Umfang verdampft.

Mit dem Verfahren jedweder Ausgestaltung wird insbesondere durch gerichtetes Erstarren der Schmelze eine Komponente für eine Gasturbine, insbesondere eine Turbinenschaufel, erzeugt.

Zur Lösung der der Erfindung im Hinblick auf eine Vorrichtung zugrundeliegenden Aufgabe wird eine Vorrichtung zum gerichteten Erstarren einer Schmelze eines ersten Metalls in einer Gießform angegeben, umfassend eine Heizkammer, welche eine Heizzone zur Warmhaltung der Schmelze und der Gießform auf einer ersten Temperatur oberhalb des Schmelzpunktes des ersten Metalls, einen unterhalb der Heizkammer angeordneten Tiegel mit einem Bad aus einem flüssigen zweiten Metall, welches sich auf einer zweiten Temperatur befindet, die unterhalb des Schmelzpunktes des ersten Metalls liegt, sowie eine Fahreinrichtung zur Bewegung der Gießform aus der Heizzone in das Bad, wobei das Bad bedeckt ist von einer schwimmenden, fließfähigen und von der Gießform durchdringbaren Deckschicht aus wärmeisolierenden keramischen Hohlkörpern.

Hinsichtlich der Vorteile, die diese erfindungsgemäße Vorrichtung bietet, gelten alle zu dem erfindungsgemäßen Verfahren gemachten Ausführungen, von deren Wiederholung an dieser Stelle abgesehen wird.

Wie bereits ausgeführt, sind die Heizkammer und der Tiegel vorzugsweise gegeneinander bewegbar, um zur gerichteten Erstarrung der Schmelze in der Gießform die Heizzone in der Heizkammer und die Deckschicht in dem Tiegel in eine gewünschte enge räumliche Beziehung zueinander bringen zu können.

Ebenfalls ist es bevorzugt, die Deckschicht in der Vorrichtung seitlich zu umgrenzen von einem auf dem Bad schwimmenden und durch den Auftrieb dichtend gegen die Heizkammer gepreßten Ring. Ein dichtendes Anliegen des Rings an der Unterseite der Heizkammer kann ermöglicht sein durch die vorstehend beschriebene Ausführung, bei der die Heizkammer und der Tiegel gegeneinander bewegbar sind. Der Ring trägt wesentlich dazu bei, die Deckschicht gegenüber der Heizzone und der Oberfläche des Bades zu fixieren, wobei ein Austreten von Wärmestrahlung aus der Heizkammer in Richtung des Bades zuverlässig verhindert werden kann. Damit ist auch gewährleistet, daß die Deckschicht unmittelbar mit der hohen Temperatur der Heizzone beaufschlagt und somit innerhalb der Deckschicht ein besonders hoher Temperaturgradient erreicht wird. Der Ring kann gegebenenfalls begleitet sein von einem geeignet ausgebildeten Überlauf an dem Tiegel, über den das zweite Metall aus dem Bad entweichen kann, wenn eine Gießform eingetaucht wird. Die Frage, ob ein Überlauf vonnöten ist, ist selbstverständlich in jedem Einzelfall unter Berücksichtigung aller Gegebenheiten, insbesondere der Geometrie des Bades und des jeweils von einer Gießform zu verdrängenden Volumens zu entscheiden.

Hinsichtlich der Bildung der Deckschicht mit Schüttgut aus von dem zweiten Metall nicht benetzbaren keramischen Hohlkörpern aus Mullit oder dergleichen oder pulverförmigen Hohlkörpern aus Aluminium-, Magnesium- oder Zirkonoxid, jeweils mit bestimmten Abmessungen, sei auf die obigen Ausführungen zu entsprechenden Weiterbildungen des erfindungsgemäßen Verfahrens verwiesen.

Die Deckschicht ist vorzugsweise so ausgeführt und angeordnet, daß der Abstand zwischen der Heizzone und der Oberfläche des Bades möglichst klein ist, um einen möglichst großen Temperaturgradienten zu erzeugen.

Vorzugsweise hat die Deckschicht eine Dicke zwischen 30 mm und 50 mm, um eine ausreichende Wärmeisolierung zu gewährleisten.

Die Vorrichtung ist mit weiterem Vorzug umschlossen von einem evakuierbaren und/oder mit einem Schutzgas befüllbaren Schutzgefäß. Dadurch kann die Einwirkung schädlicher Gase wie z. B. Sauerstoff auf das erste Metall oder das zweite Metall oder, durch Bildung eines Vakuums in dem Schutzgefäß, die Ausbreitung von Wärme durch Konvektion verhindert werden. In diesem Zusammenhang sei unter Vakuum eine Atmosphäre verstanden, die einen Wert von 10⁻³ mbar nicht überschreitet, vorzugsweise unter 10⁻⁴ mbar liegt. Die Temperatur im Inneren des Schutzgefäßes kann auf einem Wert bis zu 300 °C liegen, was insbesondere auch sicherstellt, daß organische Ablagerungen durch den zur Aufrechterhaltung des Vakuums erforderlichen Pumpprozeß entfernt werden und weder die Vorrichtung noch die darin befindlichen flüssigen Metalle beeinträchtigen können.

Ausführungsbeispiele der Erfindung gehen aus der Zeichnung hervor. Zur Verdeutlichung spezifischer Einzelheiten ist die Zeichnung nicht maßstabsgetreu und gegebenenfalls leicht verzerrt ausgeführt. Im einzelnen zeigen:
FIG 1 einen vertikalen Schnitt durch eine erfindungsgemäße Vorrichtung mit einer Gießform, die eine abzukühlende Schmelze enthält;
FIG 2 eine Ansicht des Bades mit einem Ausführungsbeispiel für die Deckschicht.
FIG 3 eine gerichtet erstarrte Turbinenschaufel mit stengelkristallinem Gefüge.

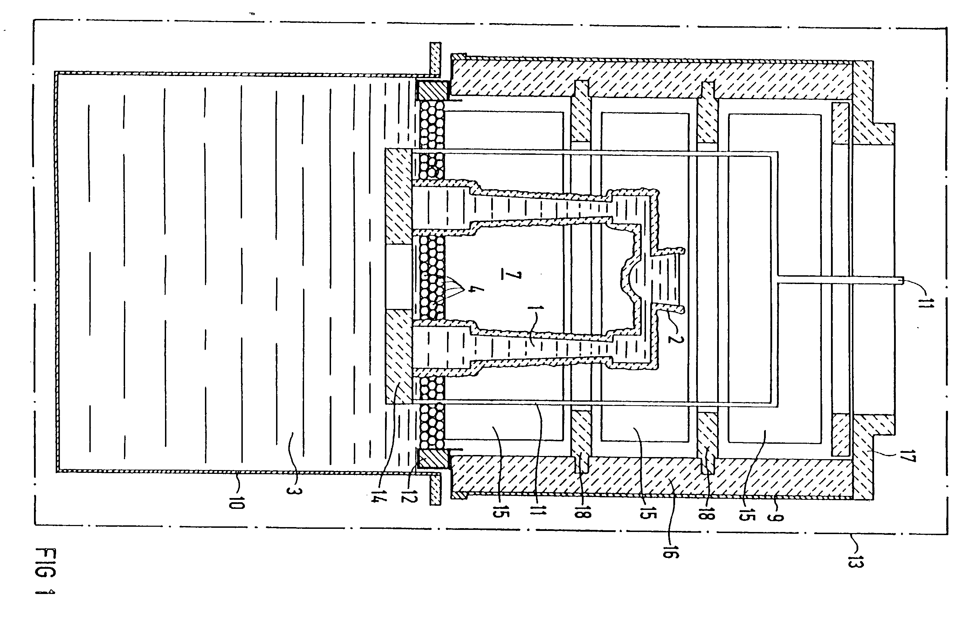

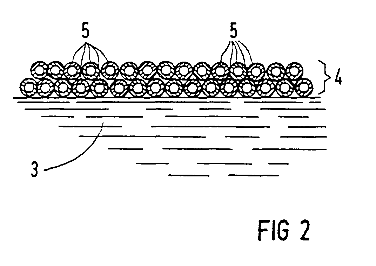

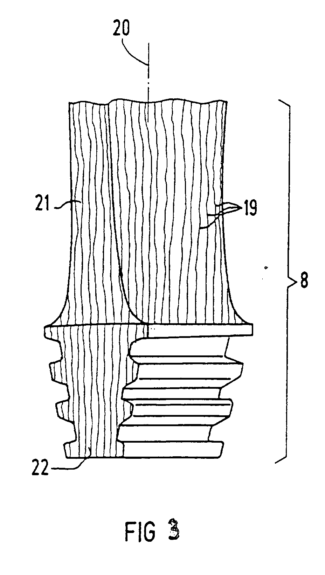

Figur 1 zeigt eine Schmelze 1 eines ersten Metalls in einer Gießform 2, welche zum Zwecke der Abkühlung in ein Bad 3 eines flüssigen zweiten Metalls, welches sich auf einer zweiten Temperatur befindet, die wesentlich geringer ist als die erste Temperatur der Schmelze 1, einzutauchen ist. Als zweites Metall findet vorzugsweise Zinn Verwendung, wobei die zweite Temperatur auf einen Wert unterhalb von 300° C, selbstverständlich jedoch oberhalb des Schmelzpunktes des Zinns bei 254° C, eingestellt wird. Das Bad 3 ist abgedeckt von einer Deckschicht 4, die aus einem fließfähigen, wärmeisolierenden Schüttgut aus keramischen Hohlkörpern 5 (vgl. hierzu Figur 2) abgedeckt ist. Die Deckschicht 4 hat die Aufgabe, einen Wärmeeintrag aus der Heizzone 7, in der die Gießform 2 mit der Schmelze 1 zunächst gehalten wird und die sich auf einer sehr hohen ersten Temperatur, insbesondere um 1600° C, befindet, in das Bad 3 zu verhindern, so daß sich im Inneren der Deckschicht 4 ein möglichst hohes Temperaturgefälle, entsprechend einem besonders hohen Temperaturgradienten, einstellt. Aufgrund des Wärmeeintrags in die Schmelze 1 und die Gießform 2 in der Heizzone 7 und aufgrund des Wärmeaustrags aus der Schmelze 1 und der Gießform 2 in dem Bad 3 stellt sich in der Schmelze 1 in dem Bereich, wo sie die Deckschicht 4 durchquert, ebenfalls ein hoher Temperaturgradient ein, welcher ein gerichtetes Erstarren der Schmelze 1 zu einem Werkstück oder mehreren Werkstücken, insbesondere einer Turbinenschaufel 8 (vgl. Figur 3), mit stengelkristallinem oder einkristallinem Gefüge bewirkt. Die Heizzone 7 befindet sich in einer Heizkammer 9, die auf einen Tiegel 10 aufgesetzt ist, welcher das Bad 3 enthält. In das Innere der Heizkammer 9 ragt eine Fahreinrichtung 11, symbolisiert durch ein Haltegestell 11, mit der bzw. mit dem die Gießform 2 verfahrbar und insbesondere aus der Heizzone 7 in das Bad 3 eintauchbar ist. Eine.Abdichtung des Bades 3, und damit verbunden eine gewünschte Positionierung des Bades 3 und der Deckschicht 4 relativ zur Heizzone 7, wird erreicht mittels eines auf dem Bad 3 schwimmenden und die Deckschicht 4 umgrenzenden Rings 12. Die ganze Vorrichtung ist umschlossen von einem schematisch angedeuteten Schutzgefäß 13, insbesondere zu dem Zweck, Sauerstoff, welcher das Bad 3 oder die Schmelze 1 oxidieren könnte, aus der Vorrichtung fernzuhalten. Zu diesem Zweck kann das Schutzgefäß 13 evakuiert und/oder mit einem geeigneten Schutzgas, wie z.B. Argon, befüllt werden.

Die Gießform 2 ruht auf einer Kühlplatte 14, die auch dann teilweise in das Bad 3 eintauchen soll, wenn die Gießform 2 selbst dies nicht tut. Dies dient dazu, den unteren Bereich der Gießform 2 gegebenenfalls bereits vor dem Eingießen der Schmelze 1 abzukühlen, um für die gerichtete Erstarrung der Schmelze 1, welche durch langsames Eintauchen der Gießform 2 in das Bad 3 bewerkstelligt wird, eine geeignete anfängliche Temperaturverteilung sicherzustellen. Die Kühlplatte 14 kann gegebenenfalls entfallen. In der Heizzone 7 vertikal übereinander angeordnet sind mehrere Heizelemente 15, beispielsweise Widerstandsheizelemente, induktiv wirkende Suszeptoren oder dergleichen, und die Heizkammer 9 ist ausgekleidet mit einer Isolierauskleidung 16. Abgedeckt ist die Heizkammer 9 mit einem Deckel 17, der einen entsprechenden Durchlaß für das Haltegestell 11 aufweist. Zwischen den Heizelementen 15 angeordnet sind Isolierringe 18, die es je nach Größe und Gestalt der Gießform 2 gegebenenfalls gestatten, eines oder mehrere der Heizelemente 15, beginnend von oben, unbenutzt zu lassen oder in der jeweils erzeugten Heizleistung im Hinblick auf eine gewünschte Verteilung der Temperatur anzupassen.

Figur 2 zeigt ein Ausführungsbeispiel für die Deckschicht 4 auf dem Bad 3. Die besonders bevorzugte Ausführung gemäß Figur 2 zeigt eine Deckschicht 4, gebildet aus keramischen Hohlkugeln 5. Wie bereits erläutert, sind solche Hohlkugeln 5 aufgrund ihrer guten Schwimmfähigkeit für den angestrebten Zweck besonders geeignet. Ein geeigneter Werkstoff für diese Hohlkugeln ist die Siliziumdioxid-Aluminiumoxid-Keramik Mullit. Diese Keramik wird auch nicht von Metallen wie Zinn und Aluminium benetzt und kann somit eine besonders gute Abschirmung des üblicherweise höchstens 500° C, vorzugsweise höchstens 300° C, heißen Bades 3 gegen die Heizzone 7, von der eine Wärmestrahlung ausgeht, die einer Temperatur der Größenordnung von 1600° C entsprechen kann, bewirken. Es versteht sich, daß die Deckschicht 4 so dick sein muß, daß sie diese Wärmestrahlung weitgehend vollständig abschirmt, daß sie, mit anderen Worten gesagt, für Wärmestrahlung "optisch dicht" ist.

Figur 3 zeigt eine Turbinenschaufel 8, die durch gerichtetes Erstarren einer Schmelze 1, wie dargestellt in Figur 1, erhalten wird. Das stengelkristalline Gefüge 19, das an der Oberfläche einer Turbinenschaufel 8 in aller Regel deutlich sichtbar ist, ist dargestellt durch entsprechende Linien. Dieses Gefüge 19 vermag die Belastbarkeit der Turbinenschaufel 8 gegenüber einer konventionell gegossenen Turbinenschaufel deutlich zu verbessern, wenn es entlang derjenigen Richtung 20 ausgerichtet ist, entlang derer die Turbinenschaufel 8 hauptsächlich belastet wird. Diese Richtung 20 ist die Längsachse 20, entlang derer unter betrieblicher Belastung Zentrifugalkräfte sowie die wesentlichen Wärmedehnungen gerichtet sind. Der übliche Aufbau der Turbinenschaufel 8 ist ansatzweise angedeutet: sie besitzt einen (nur teilweise sichtbaren) Blatteil 21, der das funktionell wesentliche Teil ist, und einen Fußteil 22, an dem sie zu befestigen ist.

## Patentansprüche

1. Verfahren zum gerichteten Erstarren einer Schmelze (1) eines ersten Metalls in einer Gießform (2), umfassend Bereitstellung der Schmelze (1) in der Gießform (2) auf einer ersten Temperatur oberhalb des Schmelzpunktes des ersten Metalls und anschließendes Abkühlen der Schmelze (1) in der Gießform (2) durch Eintauchen der Gießform (2) in ein Bad (3) aus einem flüssigen zweiten Metall, welches sich auf einer zweiten Temperatur befindet, die unterhalb des Schmelzpunktes des ersten Metalls liegt,
**dadurch gekennzeichnet,** daß das Bad (3) bedeckt ist von einer schwimmenden, fließfähigen Deckschicht (4) aus wärmeisolierenden keramischen Hohlkörpern (5) und die Gießform (2) mit der Schmelze (1) durch die Deckschicht (4) hindurch in das Bad (3) eingetaucht wird.

2. Verfahren nach Anspruch 1, bei dem die Hohlkörper (5) aus von dem zweiten Metall nicht benetzbarem Material bestehen.

3. Verfahren nach Anspruch 2, bei dem die Hohlkörper (5) Hohlkugeln (5) sind.

4. Verfahren nach Anspruch 1, 2 oder 3, bei dem die Hohlkörper (5) aus Mullit bestehen und Außendurchmesser zwischen 0,5 mm und 3 mm, vorzugsweise von etwa 1 mm, haben.

5. Verfahren nach Anspruch 1, 2 oder 3, bei dem die Hohlkörper (5) aus Aluminium-, Magnesium- oder Zirkonoxid bestehen und Außendurchmesser zwischen 0,06 mm und 0,4 mm aufweisen.

6. Verfahren nach einem der vorhergehenden Ansprüche, bei dem die Gießform (2) mit der Schmelze (1) zunächst in einer Heizzone (7) auf der ersten Temperatur gehalten und anschließend aus der Heizzone (7) in das Bad (3) eingetaucht wird, wobei zumindest dann, wenn die Gießform (2) in die Deckschicht (4) eintaucht, die Deckschicht (4) unmittelbar an die Heizzone (7) heranreicht.

7. Verfahren nach einem der vorhergehenden Ansprüche, bei dem die Deckschicht (4) während des Eintauchens der Gießform (2) in das Bad (3) eine Dicke zwischen 30 mm und 50 mm hat.

8. Verfahren nach einem der vorhergehenden Ansprüche, welches zur Vermeidung der Entstehung und/oder Beseitigung oxidischer Schlacken auf dem Bad (3) unter Ausschluß von Sauerstoff, vorzugsweise unter Vakuum, durchgeführt wird.

9. Verfahren nach Anspruch 8, bei dem die Deckschicht (4) unter einem Vakuum mit einem Restdruck von höchstens 10⁻³ mbar, vorzugsweise höchstens 10⁻⁴ mbar, gehalten wird.

10. Verfahren nach einem der vorhergehenden Ansprüche, bei dem das erste Metall eine Nickelbasis- oder Kobaltbasis-Legierung, insbesondere eine Superlegierung, ist.

11. Verfahren nach einem der vorhergehenden Ansprüche, bei dem das zweite Metall Aluminium oder Zinn, vorzugsweise Zinn, ist.

12. Verfahren nach nach Anspruch 11, bei dem das zweite Metall Zinn ist und die zweite Temperatur unterhalb von 500°C, vorzugsweise unterhalb von 300°C, liegt.

13. Verfahren nach einem der vorhergehenden Ansprüche, bei dem durch gerichtetes Erstarren der Schmelze (1) eine Komponente(8) für eine Gasturbine, insbesondere eine Turbinenschaufel (8), erzeugt wird.

14. Vorrichtung zum gerichteten Erstarren einer Schmelze (1) eines ersten Metalls in einer Gießform (2), umfassend eine Heizkammer (9), welche eine Heizzone (7) zur Warmhaltung der Schmelze (1) und der Gießform (2) auf eine erste Temperatur oberhalb des Schmelzpunktes des ersten Metalls, einen unterhalb der Heizkammer (9) angeordneten Tiegel (10) mit einem Bad (3) aus einem flüssigen zweiten Metall, welches sich auf einer zweiten Temperatur befindet, die unterhalb des Schmelzpunktes des ersten Metalls liegt, sowie eine Fahreinrichtung (11) zur Bewegung der Gießform (2) aus der Heizzone (7) in das Bad (3),
**dadurch gekennzeichnet,** daß
das Bad (3) bedeckt ist von einer schwimmenden, fließfähigen und von der Gießform (2) durchdringbaren Deckschicht (4) aus wärmeisolierenden keramischen Hohlkörpern (5).

15. Vorrichtung nach Anspruch 14, bei der die Heizkammer (9) und der Tiegel (10) gegeneinander bewegbar sind.

16. Vorrichtung nach Anspruch 14 oder 15, bei der die Deckschicht (4) seitlich umgrenzt wird von einem auf dem Bad (3) schwimmenden und dichtend gegen die Heizkammer (9) preßbaren Ring (12).

17. Vorrichtung nach einem der Ansprüche 14 bis 16, bei der die Hohlkörper (5) aus von dem zweiten Metall nicht benetzbarem Material bestehen.

18. Vorrichtung nach einem der Ansprüche 14 bis 17, bei der die Hohlkörper (5) Hohlkugeln (5) sind.

19. Vorrichtung nach Anspruch 18, bei der die Hohlkörper (5) aus Mullit bestehen und Außendurchmesser zwischen 0,5 mm und 3 mm, vorzugsweise von etwa 1 mm, haben.

20. Vorrichtung nach Anspruch 18, bei dem die Hohlkörper (5) aus Aluminium-, Magnesium- oder Zirkonoxid bestehen und Außendurchmesser zwischen 0,06 mm und 0,4 mm aufweisen.

21. Vorrichtung nach einem der Ansprüche 14 bis 20, bei der die Deckschicht (4) bis an die Heizkammer (9) heranreicht.

22. Vorrichtung nach einem der Ansprüche 14 bis 21, bei der die Deckschicht (4) eine Dicke zwischen 30 mm und 50 mm hat.

23. Vorrichtung nach einem der Ansprüche 14 bis 22, welche von einem evakuierbaren und/oder mit einem Schutzgas befüllbaren Schutzgefäß (13) umschlossen ist.

## Claims

1. Process for the directional solidification of a melt (1) of a first metal in a casting mould (2), comprising the preparation of the melt (1) in the casting mould (2) at a first temperature above the melting point of the first metal and subsequent cooling of the melt (1) in the casting mould (2) as a result of the dipping of the casting mould (2) into a bath (3) of a liquid second metal having a second temperature which is below the melting point of the first metal, characterized in that the bath (3) is covered by a floating flowable covering layer (4) consisting of thermally insulating ceramic hollow bodies (5), and the casting mould (2) together with the melt (1) is dipped through the covering layer (4) into the bath (3).

2. Process according to Claim 1, in which the hollow bodies (5) consist of material not wettable by the second metal.

3. Process according to Claim 2, in which the hollow bodies (5) are hollow balls (5).

4. Process according to Claim 1, 2 or 3, in which the hollow bodies (5) consist of mullite and have outside diameters of between 0.5 mm and 3 mm, preferably of approximately 1 mm.

5. Process according to Claim 1, 2 or 3, in which the hollow bodies (5) consist of aluminium oxide, magnesium oxide or zirconium oxide and have outside diameters of between 0.06 mm and 0.4 mm.

6. Process according to one of the preceding claims, in which the casting mould (2) together with the melt (1) is first maintained at the first temperature in a heating zone (7) and is subsequently dipped out of the heating zone (7) into the bath (3), the covering layer (4) reaching directly up to the heating zone (7) at least when the casting mould (2) dips into the covering layer (4).

7. Process according to one of the preceding claims, in which the covering layer (4) has a thickness of between 30 mm and 50 mm while the casting mould (2) is being dipped into the bath (3).

8. Process according to one of the preceding claims, which is executed with the execution of oxygen, preferably under a vacuum, for preventing the occurrence of and/or for eliminating oxidic slags on the bath (3).

9. Process according to Claim 8, in which the covering layer (4) is maintained under the vacuum at a residual pressure of at most 10⁻³ mbar, preferably at most 10⁻⁴ mbar.

10. Process according to one of the preceding claims, in which the first metal is a nickel-based or cobalt-based alloy, especially a superalloy.

11. Process according to one of the preceding claims, in which the second metal is aluminium or tin, preferably tin.

12. Process according to Claim 11, in which the second metal is tin and the second temperature is below 500°C, preferably below 300°C.

13. Process according to one of the preceding claims, in which the component (8) for a gas turbine, especially a turbine blade (8), is produced by the directional solidification of the melt (1).

14. Apparatus for the directional solidification of a melt (1) of a first metal in a casting mould (2), comprising the heating chamber (9) having a heating zone (7) for maintaining the melt (1) and the casting mould (2) at a first temperature above the melting point of the first metal, a crucible (10) arranged underneath the heating chamber (9) and with a bath (3) of a liquid second metal having a second temperature which is below the melting point of the first metal, and a travelling device (11) for moving the casting mould (2) out of the heating zone (7) into the bath (3), characterized in that the bath (3) is covered by a floating flowable covering layer (4) which consists of thermally insulating ceramic hollow bodies (5) and through which the casting mould (2) can penetrate.

15. Apparatus according to Claim 14, in which the heating chamber (9) and the crucible (10) are moveable relative to one another.

16. Apparatus according to Claim 14 or 15, in which the covering layer (4) is delimited laterally by a ring (12) which floats on the bath (3) and which can be pressed sealingly against the heating chamber (9).

17. Apparatus according to one of Claims 14 to 16, in which the hollow bodies (5) consist of material not wettable by the second metal.

18. Apparatus according to one of Claims 14 to 17, in which the hollow bodies (5) are hollow balls (5).

19. Apparatus according to Claim 18, in which the hollow bodies (5) consist of mullite and have outside diameters of between 0.5 mm and 3 mm, preferably of approximately 1 mm.

20. Apparatus according to Claim 18, in which the hollow bodies (5) consist of aluminium oxide, magnesium oxide or zirconium oxide and have outside diameters of between 0.06 mm and 0.4 mm.

21. Apparatus according to one of Claims 14 to 20, in which the covering layer (4) reaches up to the heating chamber (9).

22. Apparatus according to one of Claims 14 to 21, in which the covering layer (4) has a thickness of between 30 mm and 50 mm.

23. Apparatus according to one of Claims 14 to 22, which is surrounded by a protective vessel (13) which can be evacuated and/or filled with a protective gas

## Revendications

1. Procédé de solidification dirigée d'une masse (1) fondue d'un premier métal dans une lingotière (2) de coulée, comprenant la mise à disposition de la masse (1 ) fondue dans la lingotière (2) de coulée à une première température supérieure au point de fusion du premier métal et ensuite le refroidissement de la masse (1) fondue dans la lingotière (2) de coulée par immersion de la lingotière (2) de coulée dans un bain (3) en un deuxième métal liquide, qui se trouve à une deuxième température qui est inférieure au point de fusion du premier métal,
caractérisé en ce que le bain (3) est recouvert d'une couche (4) de couverture flottante et susceptible de s'écouler en des corps (5) creux céramiques, isolants du point de vue thermique et la lingotière (2) de coulée est immergée avec la masse (1) fondue dans le bain (3) en passant à travers le couche (4) de recouvrement.

2. Procédé suivant la revendication 1, dans lequel les corps (5) creux sont en un matériau qui ne peut pas être mouillé par le deuxième métal.

3. Procédé suivant la revendication 2, dans lequel les corps (5) creux sont des billes (5) creuses.

4. Procédé suivant la revendication 1, 2 ou 3, dans lequel les corps (5) creux sont en mullite et ont un diamètre extérieur compris entre 0,5 mm et 3 mm et de préférence d'environ 1 mm.

5. Procédé suivant la revendication 1, 2 ou 3, dans lequel les corps (5) creux sont en oxyde d'aluminium, en oxyde de magnésium ou en oxyde de zirconium et ont un diamètre extérieur compris entre 0,06 mm et 0,4 mm.

6. Procédé suivant l'une des revendications précédentes, dans lequel la lingotière (2) de coulée avec la masse (1) fondue est d'abord maintenue à une première température dans une zone (7) de chauffage et ensuite plongée de la zone (7) de chauffage dans le bain, la couche (4) de recouvrement allant directement jusqu'à la zone (7) de chauffage, au moins lorsque la lingotière (2) de coulée pénètre dans la couche (4) de recouvrement.

7. Procédé suivant l'une des revendications précédentes, dans lequel la couche (4) de recouvrement a, pendant l'immersion de la lingotière (2) de coulée dans le bain (3), une épaisseur comprise entre 30 mm et 50 mm.

8. Procédé suivant l'une des revendications précédentes, qui, pour éviter la formation de scories oxydées et/ou pour les éliminer sur le bain, est effectué à l'abri de l'air, de préférence sous vide.

9. Procédé suivant la revendication 8, dans lequel la couche (4) de recouvrement est maintenue sous un vide avec une pression résiduelle de 10⁻³ mbars au plus, de préférence de 10⁻⁴ mbars au plus.

10. Procédé suivant l'une des revendications précédentes, dans lequel le premier métal est un alliage à base de nickel ou à base de cobalt, notamment un superalliage.

11. Procédé suivant l'une des revendications précédentes, dans lequel le deuxième métal est de l'aluminium ou de l'étain, de préférence de l'étain.

12. Procédé suivant la revendication 11, dans lequel le deuxième métal est de l'étain et la deuxième température est inférieure à 500°C et de préférence inférieure à 300°C.

13. Procédé suivant l'une des revendications précédentes, dans lequel on produit par solidification dirigée de la masse (1) fondue un élément (8) pour une turbine à gaz, notamment une aube (8) de turbine.

14. Dispositif de solidification dirigée d'une masse (1) fondue d'un premier métal dans une lingotière (2) de coulée, comprenant une chambre (9) de chauffage ayant une zone (7) de chauffage pour maintenir la masse (1) fondue et la lingotière (2) de coulée à une première température supérieure au point de fusion du premier métal, un creuset (10) disposé en-dessous de la chambre (9) de chauffage et ayant un bain (3) d'un deuxième métal liquide, qui se trouve à une deuxième température qui est inférieure au point de fusion du premier métal, ainsi qu'un dispositif (11) de déplacement pour faire passer la lingotière (2) de coulée de la zone (7) de chauffage dans le bain (3),
caractérisé en ce que le bain (3) est recouvert d'une couche (4) de recouvrement en des corps (5) creux céramiques, isolants du point de vue thermique, qui est flottante, qui est susceptible de s'écouler et qui peut être traversée par la lingotière (2) de coulée.

15. Dispositif suivant la revendication 14, dans lequel la chambre (9) de chauffage et le creuset (10) peuvent se déplacer l'un par rapport à l'autre.

16. Dispositif suivant la revendication 14 ou 15, dans lequel la couche (4) de recouvrement est limitée latéralement par un anneau (12) flottant sur le bain (3) et pouvant être pressé de manière étanche sur la chambre (9) de chauffage.

17. Dispositif suivant l'une des revendications 14 à 16, dans lequel les corps (5) creux sont en un matériau qui ne peut pas être mouillé par le deuxième métal.

18. Dispositif suivant l'une des revendications 14 à 17, dans lequel les corps (5) creux sont des billes (5) creuses.

19. Dispositif suivant la revendication 18, dans lequel les corps (5) creux sont en Mullit et ont un diamètre extérieur compris entre 0,5 mm et 3 mm, de préférence de 1 mm environ.

20. Dispositif suivant la revendication 18, dans lequel les corps (5) creux sont en oxyde d'aluminium, en oxyde de magnésium ou en oxyde de zirconium et ont un diamètre extérieur compris entre 0,06 mm et 0,4 mm.

21. Dispositif suivant l'une des revendications 14 à 20, dans lequel la couche (4) de recouvrement va jusqu'à la chambre (9) de chauffage.

22. Dispositif suivant l'une des revendications 14 à 21, dans lequel la couche (4) de recouvrement a une épaisseur comprise entre 30 mm et 50 mm.

23. Dispositif suivant l'une des revendications 14 à 22, qui est entouré d'un récipient (13) de protection qui peut être mis sous vide et/ou qui peut être empli d'un gaz de protection.
